# FASCICULE DE BREVET EUROPEEN

(11) **EP 0 402 277 B1**
(45) Date de publication et mention de la délivrance du brevet: **11.08.1993**
(21) Numéro de dépôt: 90420245.4
(22) Date de dépôt: 21.05.1990
(51) Int. Cl.: G01R 19/165, G01R 29/18

(54) **Dispositif de signalisation pour un poste de distribution électrique**
Anordnung zur Anzeige für ein elektrisches Unterwerk
Displaying device for an electric distributing substation

(30) Priorité: 09.06.1989 FR 8907766
(43) Date de publication de la demande: 12.12.1990
(73) Titulaire: MERLIN GERIN, F-38240 Meylan (FR)
(72) Inventeur: Barthes, Jacques, F-38050 Grenoble Cédex (FR); Cote, Alain, F-38050 Grenoble Cédex (FR)
(74) Mandataire: Hecké, Gérard

(56) Documents cités:
- CH-A- 109 731
- DE-A- 2 600 253
- DE-B- 2 319 252
- US-A- 4 251 770

## Description

### DISPOSITIF DE SIGNALISATION POUR UN POSTE DE DISTRIBUTION ELECTRIQUE.

L'invention est relative à un dispositif de signalisation pour un poste de distribution électrique raccordé à un réseau à haute tension comprenant un premier indicateur de présence de tension ayant:
- un circuit de détection à diviseur capacitif ayant un premier condensateur connecté au réseau,
- un pont redresseur inséré en série entre le premier condensateur et la terre,
- un deuxième condensateur branché à la sortie du pont redresseur, le premier condensateur constituant un générateur de courant qui charge le deuxième condensateur à travers le pont redresseur,
- et un voyant destiné à s'allumer en cas de présence de tension sur le réseau.

Le voyant de l'indicateur comporte généralement une lampe au néon en série avec une résistance. Lorsque la tension aux bornes du deuxième condensateur augmente jusqu'à atteindre le seuil d'amorçage de la lampe au néon (environ 70 V), le deuxième condensateur se décharge dans la lampe à travers la résistance en provoquant un éclair lumineux. La capacité du premier condensateur à haute tension est extrêmement faible, notamment de l'ordre de 8pF. L'inconvénient de ce montage est la durée de vie limitée de la lampe au néon qui n'excède pas trente mille heures. En cas de destruction d'une lampe sur une phase, il est nécessaire de remplacer tout le module présence de tension des trois phases du poste triphasé.

L'objet de l'invention consiste à améliorer les performances et la fiabilité d'un dispositif de signalisation d'un poste de distribution électrique.

Un dispositif correspondant au préambule de la revendication 1 est par exemple divulgué dans le document US-A-4 251 770.

Le dispositif de signalisation selon l'invention est caractérisé en ce que le voyant est formé par une diode électroluminescente LED commandée par un circuit de commutation ayant un transistor unijonction TUP programmable associé à un circuit à seuil connecté en parallèle aux bornes du deuxième condensateur.

La durée de vie d'une diode LED est 5 fois supérieure à celle d'une lampe au néon, et de plus, la consommation en énergie est réduite. L'indicateur de présence de tension est autonome, et est alimenté directement par le réseau avec interposition du diviseur capacitif. L'utilisation d'un transistor unijonction TUP permet d'avoir un courant de fuite très faible dans l'état bloqué.

Le transistor unijonction TUP est relié électriquement en série avec la diode LED du voyant, et coopère avec un circuit RC connecté en parallèle aux bornes du deuxième condensateur, ledit circuit comprenant une résistance en série avec un condensateur, lequel se décharge dans la diode LED lorsque le transistor unijonction TUP devient conducteur, le point milieu du circuit RC étant relié à l'anode du transistor unijonction TUP dont la cathode est connectée à l'anode de la diode LED du voyant.

Dans un poste raccordé à un réseau en boucle, il est important de vérifier le raccordement des câbles des cellules arrivées avant la fermeture des interrupteurs ou disjoncteurs, toute discordance de phase risquant de provoquer un court-circuit sur le jeu de barres interne du poste. Cette vérification s'opère au moyen d'un indicateur de concordance de phase formé par un module autonome susceptible d'être branché entre les diviseurs capacitifs des deux indicateurs de présence de tension. L'indicateur de concordance de phase comporte :
- un pont redresseur en liaison du côté alternatif avec les deux condensateurs à haute tension des indicateurs de présence de tension
- un condensateur branché en parallèle à la sortie du pont redresseur
- un circuit de signalisation connecté en parallèle aux bornes du condensateur ayant une lampe en série avec une résistance
- et une résistance d'amortissement connectée en parallèle et sur le circuit de signalisation et sur ledit condensateur.

D'autres avantages et caractéristiques ressortiront plus clairement de la description qui va suivre d'un exemple de réalisation donné à titre d'exemple non limitatif, et représenté aux dessins annexés dans lesquels:
- la figure 1 montre le schéma électrique d'un indicateur de présence de tension ;
- la figure 2 représente le schéma électrique d'un indicateur de concordance de phase pour un poste raccordé à un réseau en boucle.

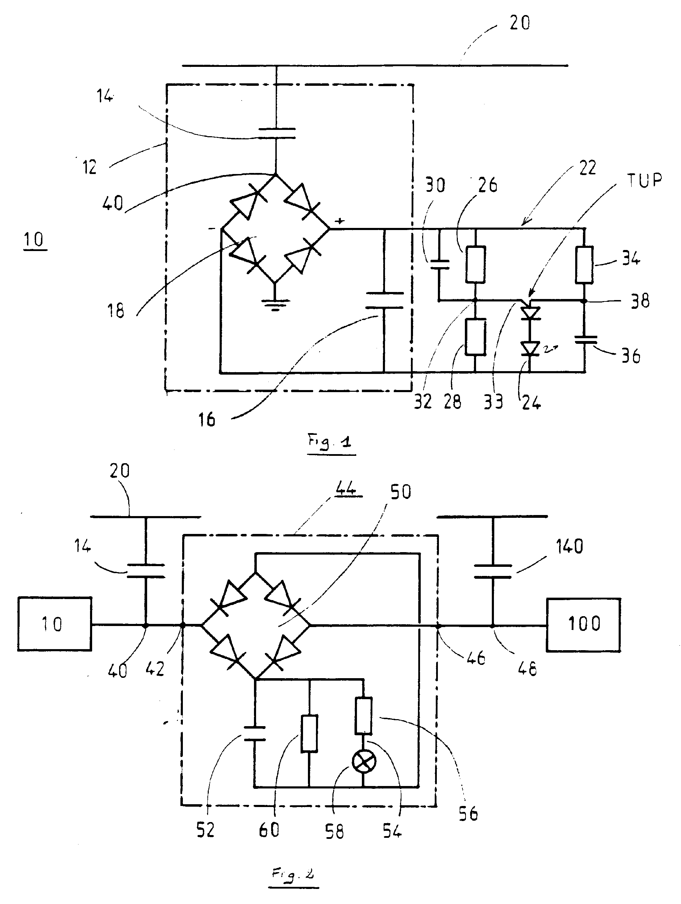

Selon la figure 1, l'indicateur de présence de tension 10 comporte un circuit de détection 12 formé par un diviseur capacitif à condensateurs 14, 16, et un pont redresseur 18 à diodes. Le premier condensateur 14 est raccordé au réseau 20 alternatif à haute tension HTA, et le pont redresseur 18 est inséré côté alternatif entre le premier condensateur 14 et la terre. Le deuxième condensateur 16 est branché à la sortie du pont redresseur 18. Le premier condensateur 14 se comporte comme un générateur de courant alternatif qui charge le deuxième condensateur 16 à travers le pont redresseur 18.
En parallèle sur le deuxième condensateur 16 est connecté un circuit de commutation 22 statique destiné à piloter un voyant 24 de signalisation formé par une diode électroluminescente LED de faible consommation.

Le circuit de commutation 22 comporte un transistor unijonction TUP programmable à impédance d'entrée élevée connecté en série avec la diode LED du voyant 24. Un diviseur résistif à résistances 26, 28 est branché en parallèle sur le deuxième condensateur 16 du circuit de mesure 12. Un condensateur 30 est connecté en parallèle sur la résistance 26, et le point milieu 32 du diviseur résistif est relié à la gâchette de commande 33 du transistor TUP pour fixer la tension de pic qui détermine le seuil de déclenchement.
Un circuit RC comprenant une résistance 34 en série avec un condensateur 36 est branché en parallèle sur le deuxième condensateur 16, et son point milieu 38 est connecté à l'anode du transistor TUP. La cathode de ce dernier est connecté à l'anode de la diode LED du voyant 24.
Le fonctionnement de l'indicateur de présence de tension 10 selon la figure 1 est le suivant :

En cas d'absence de tension sur le réseau 20, le transistor TUP est bloqué et présente un très faible courant de fuite. Le voyant 24 est éteint.

En cas de présence de tension sur le réseau 20, interviennent la charge du deuxième condensateur 16 du circuit de mesure 12, et celle du condensateur 36 du circuit RC. Le seuil de déclenchement est fixé par les résistances 26, 28 du diviseur résistif, et les tensions aux points 32, 38 de raccordement croissent jusqu'à ce que la tension au point 38 dépasse celle présente au point 32. A ce moment, le transistor TUP devient conducteur, et provoque de ce fait la décharge du condensateur 36 dans la diode électroluminescente LED du voyant 24 qui s'allume. La fréquencce de clignotement de la diode LED dépend de la valeur de l'intensité du courant de charge.

L'indicateur 10 est autonome, et est alimenté directement par le réseau 20 avec interposition du diviseur capacitif. L'indicateur 10 peut fonctionner à très faible courant, et des essais ont montré qu'un courant alternatif de quelques microampères circulant dans le circuit du premier condensateur 14 était suffisant pour provoquer le clignotement du voyant 24.

Sur la figure 2, le point milieu 40 entre le premier condensateur 14 et le pont redresseur 18 de l'indicateur de présence de tension 10 peut être raccordé à une première borne 42 d'un indicateur de concordance de phase 44, lequel comporte une deuxième borne 46 destinée à être raccordée au point milieu 48 d'un autre indicateur de présence de tension 100. Ce dernier comporte un condensateur 140 d'un diviseur capacitif branché au réseau 20.

Les deux indicateurs de présence de tension 10, 100 sont identiques, et sont intégrés dans deux sous-ensembles arrivées d'un poste électrique de distribution pour réseau en boucle de type décrit dans le brevet français N° 2507 835. Chaque sous-ensemble arrivée comprend un interrupteur triphasé raccordé au réseau 20 au moyen de câbles. Avant la mise en service des interrupteurs associés aux deux sous-ensembles arrivées, il faut s'assurer que les raccordements aux phases du réseau 20 ont été effectués correctement pour éviter tout court-circuit sur le jeu de barres du poste.

L'indicateur de concordance de phase 44 permet de vérifier le bon raccordement lorsque le poste est sous tension.

L'indicateur 44 comporte un pont redresseur 50 relié du côté alternatif aux deux bornes 42, 46. La sortie redressée du pont 50 est reliée à un condensateur 52. Un circuit de signalisation 54 ayant une résistance 56 en série avec une lampe au néon 58, est branché en parallèle aux bornes du condensateur 52. Une résistance d'amortissement 60 est également connectée en parallèle sur le condensateur 52 de manière à présenter une constante de temps, prédéterminée, de l'ordre de une à quatre secondes. A titre d'exemple, la résistance 60 a une valeur de 30 Mégohms, et le condensateur a une capacité de 100 nF.

L'indicateur de concordance de phase est branché temporairement aux points 40 et 48 des indicateurs de présence de tension 10, 100. Lorsque les tensions prélevées aux points 40 et 48 sont en phase, aucun courant ne circule dans le pont redresseur 50 à diodes, et le condensateur 52 ne se charge pas. La lampe au néon 58 reste alors éteinte, ce qui signifie qu'il y a concordance de phase.

En cas de discordance de phase suite à un mauvais raccordement, les tensions aux points 40 et 48 sont déphasées de 120 degrés provoquant la circulation d'un courant alternatif dans le pont redresseur 50. Le condensateur 52 se charge jusqu'à la valeur de la tension d'amorçage de la lampe au néon 58. Le clignotement de la lampe au néon 58 s'opère à une fréquence dépendante de la tension nominale du réseau 20.

L'indicateur 44 ne comporte aucune source d'alimentation interne, étant donné que l'énergie nécessaire au fonctionnement est prise sur les diviseurs capacitifs du poste. La présence de la résistance d'amortissement 60 est indispensable pour limiter l'influence d'un léger déséquilibre de tension entre phases du réseau, notamment lorsque les tensions entre les points 40, 48 sont en phase, et que leur écart par rapport à la terre est inférieure à 3 kV. Dans ce cas la lampe au néon 58 reste éteinte.

Le fonctionnement de l'indicateur 44 est possible pour des tensions de réseau 20 comprises entre 6 kV et 24 kV entre phases.

## Revendications

1. Dispositif de signalisation pour un poste de distribution électrique raccordé à un réseau (20) à haute tension, comprenant un premier indicateur de présence de tension (10) ayant:
- un circuit de détection (12) à diviseur capacitif ayant un premier condensateur (14) connecté au réseau (20),
- un pont redresseur (18) inséré en série entre le premier condensateur (14) et la terre,
- un deuxième condensateur (16) branché à la sortie du pont redresseur (18), le premier condensateur (14) constituant un générateur de courant qui charge le deuxième condensateur (16) à travers le pont redresseur (18),
- et un voyant (24) destiné à s'allumer en cas de présence de tension sur le réseau (20), caractérisé en ce que le voyant (24) est formé par une diode électroluminescente LED commandée par un circuit de commutation (22) ayant un transistor unijonction TUP programmable associé à un circuit à seuil connecté en parallèle aux bornes du deuxième condensateur (16).

2. Dispositif de signalisation selon la revendication 1, caractérisé en ce que le transistor unijonction TUP est relié électriquement en série avec la diode LED du voyant (24), et coopère avec un circuit RC connecté en parallèle aux bornes du deuxième condensateur (16), ledit circuit comprenant une résistance (34) en série avec un troisième condensateur (36), lequel se déchargé dans la diode LED lorsque le transistor unijonction TUP devient conducteur, le point milieu (38) du circuit RC étant relié à l'anode du transistor unijonction TUP dont la cathode est connectée à l'anode de la diode LED du voyant (24).

3. Dispositif de signalisation selon la revendication 2, caractérisé en ce que le circuit à seuil comporte un diviseur résistif à résistances (26, 28) ayant un point milieu (32) relié à la gâchette (33) de commande du transitor TUP, la tension à ladite gâchette (33) étant supérieure à celle du point milieu (38) du circuit RC lorsque le transistor unijonction TUP se trouve dans l'état bloqué, un quatrième condensateur (30) étant connecté en parallèle sur la résistance (26) correspondante dudit diviseur et résistif (26,28) entre la borne positive du pont redresseur (18) et le point milieu du diviseur résistif.

4. Dispositif de signalisation selon l'une des revendications 1 à 3, pour un poste d'un réseau en boucle, ayant un deuxième indicateur de présence de tension (100) dans l'autre arrivée caractérisé en ce qu'un indicateur de concordance de phase (44) est susceptible d'être branché entre les diviseurs capacitifs respectifs des deux indicateurs de présence de tension (10, 100), en étant logé dans un module autonome renfermant :
- un pont redresseur (50) en liaison du côté alternatif avec les deux condensateurs (14, 140) à haute tension des indicateurs de présence de tension (10, 100),
- un condensateur (52) branché en parallèle à la sortie du pont redresseur (50),
- un circuit de signalisation (54) connecté en parallèle aux bornes du condensateur (52), et ayant une lampe (58) en série avec une résistance (56),
- et une résistance d'amortissement (60) connectée en parallèle sur le condensateur (52) pour présenter une constante de temps prédéterminée, dont la valeur est comprise entre une à quatre secondes.

## Patentansprüche

1. Anzeigevorrichtung für eine elektrische Verteilerstation, die mit einem Hochspannungsnetz (20) verbunden ist und einen ersten Spannungsanwesenheit-Anzeiger (10) aufweist, mit:
- einer Kapazitivteiler-Detektorschaltung (12) mit einem ersten, mit dem Netz (20) verbundenen Kondensator (14),
- einer zwischen dem ersten Kondensator (14) und der Erde in Serie geschalteten Gleichrichterbrücke (18),
- einem zweiten Kondensator (16), der an den Ausgang der Gleichrichterbrücke (18) angeschlossen ist, wobei der erste Kondensator (14) einen Stromgenerator bildet, der den zweiten Kondensator (16) durch die Gleichrichterbrücke (18) auflädt,
- und eine Signallampe (24), die aufleuchtet, wenn eine Spannung auf dem Netz (20) vorhanden ist, dadurch gekennzeichnet, dass die Signallampe von einer Elektrolumineszenz-LED-Diode gebildet wird, die von einem Schaltkreis (22) gesteuert wird mit einem programmierbaren TUP-Unijunction-Transistor, der einer Schwellenschaltung zugeordnet ist, die parallel mit den Anschlussklemmen des zweiten Kondensators (16) verbunden ist.

2. Anzeigevorrichtung gemäss Anspruch 1, dadurch gekennzeichnet, dass der TUP-Unijunction-Transistor mit der LED-Diode der Signallampe (24) elektrisch in Serie geschaltet ist und mit einer RC-Verzögerungsschaltung mit Widerstand und Kondensator zusammenarbeitet, die parallel mit den Anschlussklemmen des zweiten Kondensators (16) geschaltet ist, wobei die genannte Leitung einen Widerstand (34) aufweist, der mit dem dritten Kondensator (36) in Serie geschaltet ist, der sich in die LED-Diode entlädt, wenn der TUP-Unijunction-Transistor leitend wird, wobei der in der Mitte gelegene Punkt (38) der Verzögerungsschaltung mit der Anode des TUP-Unijunction-Transistors verbunden ist, dessen Kathode mit der Anode der LED-Diode der Signallampe (24) verbunden ist.

3. Anzeigevorrichtung gemäss Anspruch 2, dadurch gekennzeichnet, dass die Schwellenschaltung einen Widerstandsteiler aufweist mit Widerständen (26, 28) mit einem in der Mitte gelegenen Punkt (32), der mit dem Steuerknopf (33) des TUP-Transistors verbunden ist, wobei die Spannung des genannten Abdrückknopfes (33) höher ist als die des in der Mitte gelegenen Punktes (38) der RC-Verzögerungsschaltung, wenn sich der TUP-Unijunction-Transistor in blockierter Lage befindet, wobei ein vierter Kondensator (30 parallel auf dem entsprechenden Widerstand (26) des genannten Widerstandteilers (26, 28) geschaltet ist, zwischen der positiven Anschlussklemme der Gleichrichterbrücke (18) und dem in der Mitte gelegenen Punkt des Widerstandteilers.

4. Anzeigevorrichtung gemäss einem der Ansprüche 1 bis 3, für eine Schleifennetz-Station, mit einem zweiten Spannungsanwesenheit-Anzeiger (100) in der anderen Stromzuführung, dadurch gekennzeichnet, dass ein Phasenübereinstimmungs-Anzeiger (44) zwischen den jeweiligen Widerstandteilern der beiden Spannungsanwesenheit-Anzeiger (10, 100) geschaltet sein kann, wobei er in einem autonomen Modul untergebracht ist, welches enthält:
- eine Gleichrichterbrücke (50), die auf der alternativen Seite mit den beiden Hochspannungs-Kondensatoren (14, 140) der Spannungsanwesenheit-Anzeiger (10, 100) in Verbindung steht,
- einen Kondensator (52), der parallel mit dem Ausgang der Gleichrichterbrücke (50) geschaltet ist,
- einer Anzeigenschaltung (54), die parallel mit den Anschlussklemmen des Kondensators (52) geschaltet ist und eine mit dem Widerstand (56) in Serie geschaltete Lampe (58) aufweist,
- einem Dämpfungswiderstand (60), der parallel auf dem Kondensator (52) geschaltet ist, um eine vorbestimmte Zeitkonstante aufzuweisen, deren Wert zwischen einer und vier Sekunden liegt.

## Claims

1. An indicating device for an electrical distribution substation connected to a high-voltage power system (20), comprising a first voltage presence indicator (10) having :
- a detection circuit (12) with capacitive divider having a first capacitor (14) connected to the power system (20),
- a rectifier bridge (18) serially connected between the first capacitor (14) and earth,
- a second capacitor (16) connected to the output of the rectifier bridge (18), the first capacitor (14) constituting a current generator which charges the second capacitor (16) via the rectifier bridge (18),
- and an indicator lamp (24) designed to light up in the case of presence of voltage on the power system (20), characterized in that the indicator lamp (24) is formed by a light-emitting diode LED controlled by a switching circuit (22) having a programmable unijunction transistor TUP associated with a threshold circuit connected in parallel to the terminals of the second capacitor (16).

2. The indicating device according to claim 1, characterized in that the unijunction transistor TUP is electrically connected in series with the diode LED of the indicator lamp (24), and cooperates with an RC circuit connected in parallel to the terminals of the second capacitor (16), said circuit comprising a resistor (34) in series with a third capacitor (36), which discharges into the diode LED when the unijunction transistor TUP is turned on, the mid-point (38) of the RC circuit being connected to the anode of the unijunction transistor TUP whose cathode is connected to the anode of the diode LED of the indicator lamp (24).

3. The indicating device according to claim 2, characterized in that the threshold circuit comprises a resistive divider with resistors (26, 28) having a mid-point (32) connected to the trigger (33) controlling the transistor TUP, the voltage at said trigger (33) being greater than that of the mid-point (38) of the RC circuit when the unijunction transistor TUP is in the off state, a fourth capacitor (30) being connected in parallel to the corresponding resistor (26) of said resistive divider (26, 28) between the positive terminal of the rectifier bridge (18) and the mid-point of the resistive divider.

4. The indicating device according to one of the claims 1 to 3, for a loop-connected power system substation, having a second voltage presence indicator (100) in the other input, characterized in that a phase coincidence indicator (44) is able to be connected between the respective capacitive dividers of the two voltage presence indicators (10, 100), being housed in an autonomous module containing :
- a rectifier bridge (50) connected on the AC side with the two high-voltage capacitors (14, 140) of the voltage presence indicators (10, 100),
- a capacitor (52) connected in parallel to the output of the rectifier bridge (50),
- an indicating circuit (54) connected in parallel to the terminals of the capacitor (52), and having a lamp (58) in series with a resistor (56),
- and a damping resistor (60) connected in parallel to the capacitor (52) to present a preset time constant, whose value is comprised between one and four seconds.
